(19) **Europäisches Patentamt / European Patent Office / Office européen des brevets**

(11) **EP 4 641 231 A1**

(12) # EUROPEAN PATENT APPLICATION

(43) Date of publication:
**29.10.2025  Bulletin 2025/44**

(21) Application number: **25167705.0**

(22) Date of filing: **01.04.2025**

(51) International Patent Classification (IPC):
**G01R 31/367** *(2019.01)*    **G01R 31/392** *(2019.01)*
**H01M 10/48** *(2006.01)*

(52) Cooperative Patent Classification (CPC):
**G01R 31/367; G01R 31/392; H01M 10/48**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **25.04.2024  US 202418645900**

(71) Applicant: HONEYWELL INTERNATIONAL INC.
**Charlotte, NC 28202 (US)**

(72) Inventors:
• **MANIKFAN, Sameer D.**
  **Charlotte, 28202 (US)**
• **TRENCHARD, Andrew J.**
  **Charlotte, 28202 (US)**
• **KN, Dinesh Kumar**
  **Charlotte, 28202 (US)**
• **VIJAYABASKAR, Rajavelu**
  **Charlotte, 28202 (US)**

(74) Representative: **Houghton, Mark Phillip**
**Patent Outsourcing Limited**
**1 King Street**
**Bakewell, Derbyshire DE45 1DZ (GB)**

(54) **SYSTEM AND METHOD FOR DETECTING AND CLASSIFYING ABNORMAL BATTERY CONDITIONS IN BATTERY ENERGY STORAGE SYSTEMS**

(57)    A system and method for detecting and classifying outlier battery cells operating abnormally in a storage battery of a battery energy storage system (BESS). A controller controls the operation of the BESS, and a battery management system (BMS) collects battery operational data from the storage battery and stores the battery data in a data repository. A prognostic agent coupled to the battery data repository uses the stored battery data to train a prognostics and fault detection model that is loaded in the controller and used to detect at least one outlier battery cell. Detected outlier battery cell and their operational data are classified using a data classification neural network to one of a plurality of fault types.

FIG. 3

**Description**

TECHNICAL FIELD

This disclosure is directed to battery energy storage systems. More specifically, it relates to a system and method for detecting and classifying outlier battery cells of a battery energy storage system to identify potentially anomalous battery cells and enable run time reliability reporting for the fail safe operation of battery energy storage systems.

BACKGROUND

Currently, most electric power is generated by centralized power plants, such as nuclear power plants, hydroelectric plants, and fossil fuel powered plants. These large facilities frequently generate power using non-renewable sources of energy, such as coal or gas. Such power plants commonly have good economies of scale, however due to various economic and operational reasons may not provide all of the power required to service the loads of the electrical grid services by the centralized power plant. Battery energy storage systems having stored power may be connected at a power plant, substation, transmission line or at a customer site to selectively use stored battery energy to supplement or provide all the power required by the grid, thereby preventing service interruptions. Battery energy storage systems (BESS) employ chemical energy storage batteries that chemically store energy such as for example a lithium ion (LiON) batteries that include Lithium Iron Phosphate (LFP) battery that are widely used in stationary battery energy storage systems, lead acid batteries (Pb), or sodium-sulfur (NAS) batteries. Battery management systems (BMS) are used to monitor the BESS. The BMS uses sensors for measuring voltage, temperature, and current flowing through a BESS battery. Real-time prognosis of sensor and cell faults are critical for ensuring the safe and reliable operation of the BESS battery. A temperature sensor fault may lead to ineffective thermal management. A weak cell due to a manufacturing defect or due to ageing can result in catastrophic failures if not detected and diagnosed.

A BESS deployment, such as a BESS container used in providing electrical power for a microgrid, comprises a large quantity of battery cells. For example, a 40 ft BESS container may have a BESS battery configured with 16 racks, each rack equipped with 15 modules, and each module having 24 sensors connected to cells arranged in 24S X 2P configuration (e.g., 2 battery banks wired in parallel of 24 battery cells wired in series). The sensors continuously monitor a total of 5760 cell voltages and 5760 cell temperatures. In a microgrid, there could be multiple BESS containers and it becomes difficult to monitor and effectively analyze the voltage and temperature parameters of multiple BESS container deployments. To effectively monitor a BESS requires some form of automation and/or machine intelligence to detect and classify cell and sensor faults.

The failure mechanism of a battery deployment using LiON chemistries is complicated because it is a nonlinear time-varying system with dynamic electrochemical and mechanical phenomena. Faults of the LiON battery system can be categorized into internal faults and external faults. The fault diagnosis and prognosis approaches of LiON systems can be classified into three types: rule-based, model-based, and data-driven methods. For example, detection of smoke or aerosols gives a late indication of critical battery failure. Upon such a detection numerous cells could be damaged. Simple rule-based methods that check the value of critical parameters, such as voltage and temperature, against fixed thresholds require these thresholds to be set conservatively (for all the ranges of normal charging, discharging and static operation) to avoid false alarms. As such, these are also insensitive and late detection of an abnormal situation may not be timely to take necessary steps to extend the life of the battery. Employing automated methods for identifying abnormal voltages or temperatures is complicated as they marginally deviate from the normal value, thus false alarms often occur, particularly when only a single parameter (voltage or temperature) is used.

The present disclosure describes a system and method for detecting and classifying outlier battery cells of a BESS battery using cell voltage and temperature data collected online by a BMS to identify potentially anomalous battery cells that may trigger critical faults in the BESS.

SUMMARY

This disclosure relates to a system and method for detecting and classifying outlier battery cells of a BESS battery using cell voltage and temperature data collected online by a BMS to identify potentially anomalous battery cells.

In a first embodiment a system is disclosed for detecting and classifying outlier battery cells operating abnormally in a storage battery of an energy storage system (BESS), the system comprises, a controller for controlling the operation of the BESS and a battery management system (BMS) coupled to the storage battery configured to collect battery operational data from the storage battery. A battery data repository coupled to the BMS receives and stores the storage battery operational data. A prognostic agent coupled to the battery data repository uses the stored battery operational data to train a prognostics and fault detection model. The prognostics and fault detection model is loaded in the controller and used to detect at least one outlier battery cell.

The detected outlier battery cell and operational data identified by the prognostics and fault detection model is classified using a data classification neural network to one of a plurality of fault types. The data classification neural network uses an adjacency weighted, temporal and spectral distance informed, outlier classifier neural network. The inputs to this neural network are the outlier cell operational battery voltage, temperature data and the current, SOC and cycle count data of all the battery cells in the storage battery. The output of the data classification neural network is the fault type.

In a second embodiment a method for detecting and classifying outlier battery cells operating abnormally in a storage battery of an energy storage system (BESS) is disclosed. The method comprises providing a controller for controlling the operation of the BESS and collecting battery operational data from the storage battery system using a battery management system (BMS) coupled to the storage battery. The method further includes storing the storage battery operational data in a battery data repository and training a prognostics and fault detection model using the battery data stored in the data repository. The trained prognostics and fault detection model is loaded in the controller and used to detect at least one outlier battery cell.

The method further includes classifying the detected outlier battery cell and its operational data to one of a plurality of fault types that uses a data classification neural network running an adjacency weighted, temporal and spectral distance informed, outlier classifier neural network. The outlier classifier neural network uses the detected outlier battery cell operational battery data and the voltage, temperature, current, SOC and cycle count data of all the battery cells contained in the storage battery with the detected at least one outlier battery cell to classify the fault type of the detected outlier battery cell.

Other technical features may be readily apparent to one skilled in the art from the following figures, descriptions, and claims.

BRIEF DESCRIPTION OF THE DRAWINGS

For a more complete understanding of this disclosure, reference is now made to the following description, taken in conjunction with the accompanying drawings, in which:

FIG. 1 is a diagram schematically illustrating a multi-level control system used in controlling a battery energy storage system;

FIG. 2 is diagram schematically illustrating the energy control system used in controlling a battery energy storage system;

FIG. 3 is diagram schematically illustrating an embodiment of an exemplary system for detecting abnormal battery conditions in battery energy storage systems according to the present disclosure;

FIG. 4 is diagram schematically illustrating an exemplary method for detecting outlier battery cells of a battery energy storage system according to the present disclosure;

FIG. 5 is diagram schematically illustrating an exemplary method for detecting a thermal runaway fault according to the present disclosure;

FIG. 6 is diagram schematically illustrating an exemplary method for detecting an internal short circuit fault according to the present disclosure;

FIG 7 is diagram schematically illustrating an exemplary data classification neural network system according to the present disclosure;

FIG. 8 is diagram schematically illustrating an exemplary method for computing adjacency weighted curve distances for battery cell outliers for the data classification neural network system; and

FIG. 9 is diagram schematically illustrating an exemplary convolutional neural network that computes cross correlation for the data classification neural network system.

DETAILED DESCRIPTION

The figures discussed below, and the various embodiments used to describe the principles of the present invention in this patent document are by way of illustration only and should not be construed in any way to limit the scope of the invention. Those skilled in the art will understand that the principles of the invention may be implemented in any type of suitably arranged device or system.

A system and method is disclosed for the real time, and battery data driven prognostics of abnormal battery cells, which is integrated with a multi-level control system for a battery energy storage system (BESS). The multi-level control system consists of a cloud hosted energy control system (ECS) executing in a SCADA server along with a virtual power plant (VPP), a microgrid ECS controller, a BESS ECS controller and BESS unit controller. The control system leverages the computing resources in a cloud hosted ECS, for training the models for battery prognostics and edge computing platform deployed at the microgrid site. The battery prognostic models are used for the real time estimation of state of charge (SOC) and state of health (SOH) of the battery of a BESS.

The BESS unit controller reads battery cell and rack level data from a hierarchical battery management system (BMS). The data includes voltage, current, temperature, SOC, and SOH of all the cells contained in a BESS battery rack. While voltage, current and temperature are measured directly from sensors attached to battery cells, SOC and SOH are inferred by the BMS. Estimation of SOC and SOH by the BMS can be inaccurate if the battery has not gone through calibration tests or full cycles of battery charge and discharge.

Battery prognostics using the system and method disclosed herein enable early detection of outlier battery cells with cell faults or different sensor faults used in the condition-based maintenance of battery modules with a purpose of avoiding abnormal situations that can result in safety incidents, such as for example fire, H2 and off-gas release and explosions. The data collected by a BESS unit controller from a BMS is sent to a cloud hosted battery data repository via the BESS ECS controller. Computing intensive resources, in the BESS prognostics system train BESS diagnostic agents using the data collected from the BMS in the field in real time. However, the cloud hosted BESS prognostics system can also be run offline to provide battery data analytics on battery cell data to identify outlier battery cells. The cloud hosted BESS prognostics downloads a trained BESS prognostics and fault prediction agent to a BESS ECS controller to execute the trained BESS prognostics and fault prediction agent.

The fault prediction agent running in the BESS ECS controller may be used to specifically detect outlier battery cells that may lead to critical faults in the BESS such as, for example, thermal run away and internal short circuits. Alternatively, since the thermal runaway and short circuit detectors run in a BESS unit controller that is a resource constrained device, a cloud hosted BESS prognostic system may be communicatively coupled with a BESS unit controller equipped inside a BESS container, and the BESS unit controller communicatively coupled directly with the BMS over a MODBUS TCP interface to enable faster response to an impending detected thermal runaway condition and/or internal short circuit fault.

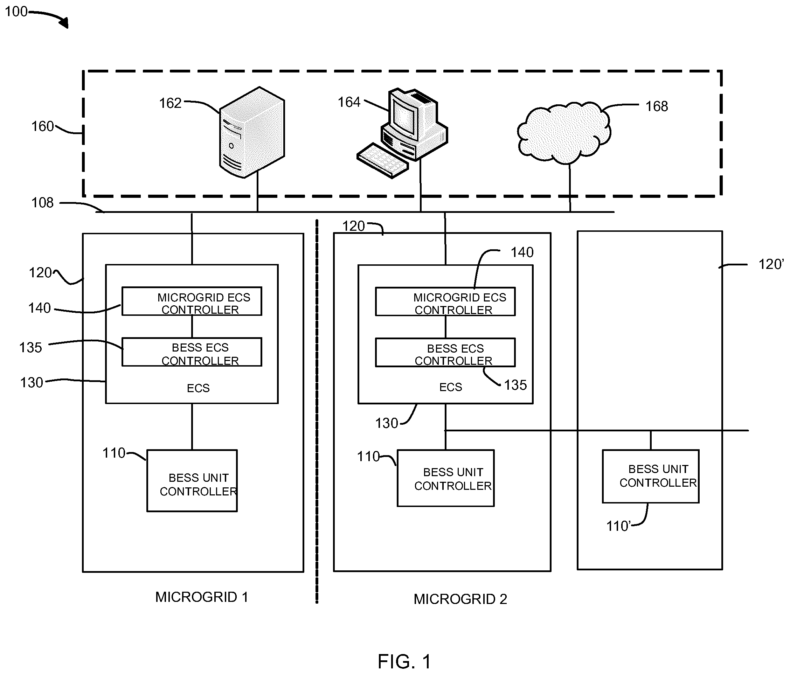

FIG. 1 illustrates an exemplary multi-level control system used in controlling a BESS. As illustrated in FIG. 1, the multi-level control system 100 consists of four hierarchical control levels. At the first control level, a BESS unit controller 110 is located in a BESS container 120. The BESS unit controller 110 is used to control the functions of a BESS container 120 and its power conversion assets. Each BESS container 120 is organized as a self-contained package that may at least include a power conversion system, a battery system, a heating ventilation, and air conditioning (HVAC) system, fire protection systems and components and sensors required to monitor the BESS container 120. Each BESS container 120 can be used to power stand-alone deployments of BESS 120 containers and their associated multi-level control system 100 such as for example, a building or a business enterprise or microgrid deployments where a single BESS container 120 or multiple BESS containers 120 can provide power to a neighborhood of homes or to a business district.

At a second control level an ECS 130 is communicatively coupled to one or more BESS unit controllers 110, 110'. The ECS 130 includes a BESS ECS controller 135 that controls the operation of one or more BESS containers 120 and a microgrid ECS (MECS) controller 140. The ECS 130 may be connected to stand-alone BESS container 120 deployments, multiple BESS container 120 deployments or to grid connected multi-container BESS deployments. For example, in FIG. 1, the ECS 130 is shown connected to both BESS unit controller 110, as well as BESS unit controller 110' of BESS container 120'.

The MECS controller 140 comprises a third control level of the multi-level control system 100. The MECS controller 140 is communicatively coupled to the BESS ECS controller 135 and manages alternate power generation assets such as for example, solar, wind, hydroelectric power that may be connected and available on the grid for use by the BESS container 120. The MECS controller 140 is arranged to provide the alternate power capabilities to either a stand-alone BESS container 120 deployment or to multiple microgrid connected BESS container deployments.

A fourth control level of the control system 100 includes a virtual power plant (VPP) 160. The VPP 160 is comprised of distributed small and medium-scale power generating units, loads and energy storage systems, that when aggregated and coordinated using software, performs functions equivalent to a centralized physical power plant. A software operating program executing on, for example, a SCADA server 162, functions as a controller that controls the VPP 160. The VPP 160 further includes an operator station 164 and an interface to the cloud 168. The SCADA server 162 may be any device that provides resources, data, services or software programs to other processing devices or clients over a network. The operator station 164 may be any computing device that provides functions for power plant operations and monitoring including display of graphics such as diagrams, systems, BESS container 120 deployments and data to a user or operator. The operator station 164 may also receive input from the user or operator to adjust or enter configurable parameters for the BESS unit controller 120, BESS ECS controller 135 and the MECS controller 140. The cloud 168 may be any computing device or technology that delivers services through the internet, including information, data storage, servers, access to databases, networking, and software. The VPP 160 can control multiple BESS containers 120 connected to the VPP 160 through a communication network 108. The VPP 160 as shown in FIG. 1 controls BESS containers 120, 120' in multigrid deployments such as the microgrid 1 and microgrid 2 illustrated in FIG. 1.

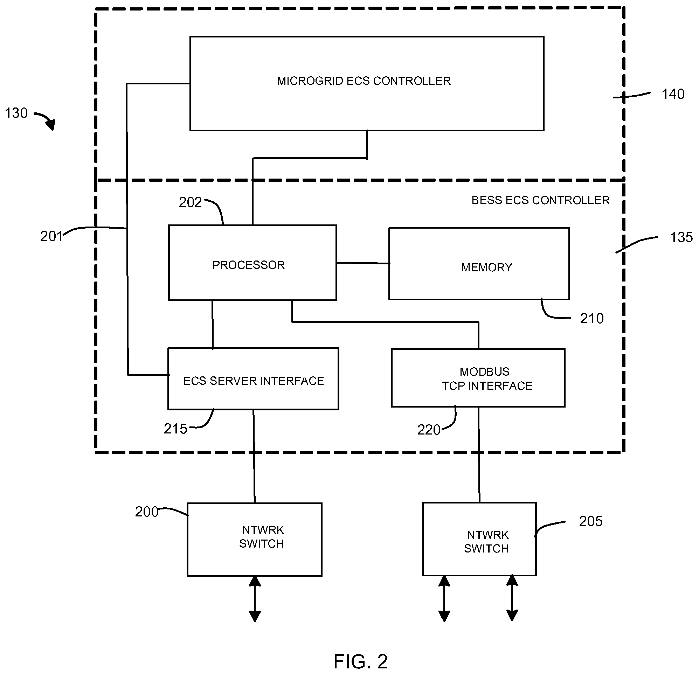

FIG. 2, illustrates the components of an exemplary ECS 130. The ECS 130 is comprised of the BESS ECS controller 135 and the MECS controller 140. The BESS ECS controller 135 and the MECS controller 140 are logically separate, however, they may be located on and execute within a common physical hardware/software controller or communicatively coupled to different physical hardware/software controllers. The BESS ECS controller 135 is comprised of at least one processor 202, at least one memory device 210, at least one ECS server interface 215 and at least one MODBUS TCP interface 220. The processor 202 executes instructions that may be loaded into memory 210. The processor 202 may include any suitable number(s) and type(s) of processing or other devices in any suitable arrangement. Example types of processing devices include microprocessors, microcontrollers, digital signal processors, field programmable gate arrays, application specific integrated circuits, and discreet circuitry.

The memory 210 represents any structure(s) capable of storing and facilitating retrieval of information (such as data, program code, and/or other suitable information on a temporary or permanent basis). The memory 210 may represent a random access memory or any other suitable volatile or non-volatile storage device(s). The memory may also include one or more components or devices supporting longer-term storage of data, such as a ready only memory, hard drive, flash memory, or optical disc.

The processor 202 executes the various programs stored in memory 210 that operates the BESS ECS controller 135 to provide references for power balancing between BESS containers 120 and power conversion assets attached to the BESS containers 120. The programs further operate to distribute the power balancing references to the BESS unit controllers 110. The BESS ECS controller 135 also takes inputs on the number of battery racks 305 that have been committed within a BESS battery 304 of a BESS container 120 in the calculation of power reference for the BESS containers 120. The BESS ECS controller 135 executes programs that calculate energy balancing taking into consideration the aggregate SOC and cycle count of different BESS containers 120 that have the same or a different number of battery racks 305 available for discharge or cut-out and not available for use.

The ECS server interface 215 provides a communication portal to network 108 through network switch 200 to the VPP 160 using a DPN3 or MQTT protocol. This communication portal from server interface 215 serves as the BESS container 120 connection to VPP 160 and level 4 of the BESS control system 100. As is seen in FIG. 2, the MECS controller 140 also includes a direct communication connection to the ECS server interface 215 through a bidirectional line 201 that allows the MECS controller 140 to have direct access to the VPP 160. The MECS controller 140 can be located and contained in the ECS 130, however, as explained above, it is logically separate from the BESS ECS controller 135.

The MODBUS TCP interface provides a Modbus TCP/IP communication portal providing Ethernet intranet communication between the BESS ECS controller 135 and BESS unit controllers 110 in either single or multiple BESS container 120 deployments using network switch 205. The ECS 130 functions as a DNP3 outstation that interworks with a DNP3 master running on server 162 on the VPP 160.

The VPP 160 performs centralized co-ordination of distributed microgrids. The VPP 160 is tasked to calculate reference power for either supplying power to the microgrid or drawing power from a main grid to which multiple microgrids are connected. The MECS controller 140 may receive an operating schedule from the VPP 160. For example, a schedule for the exchange of power between a microgrid and the grid, or a schedule of grid electricity prices associated with power import or export in situations where the import and export of power has a difference in a price setpoint, or simply a schedule of use cases for which one or more BESS containers 120 along with generation assets and loads are to be committed. For example, renewable smoothing for export between 09:00 and 12:00 hours, frequency regulation support between 12:00 and 17:00 hours and grid peak demand support between 17:00 and 20:00 hours.

With information from the VPP 160, the MECS controller 140 computes a schedule for charging or discharging one or more BESS containers 120. The MECS controller 140 computes the schedule for charging or discharging considering the schedule provided by the VPP 160, but also the local generation loads, frequency, and voltage within a microgrid.

The VPP 160 is further tasked in the balancing of the supply and demand for power in multiple microgrids using economic optimization objectives, peak demand forecasts, and renewable energy generation forecasts. For example, the VPP 160 may receive information from the cloud 168 from energy trading data that generates market bids and market clearing prices from an energy market operator. The information may be used on demand as information response signals to the MECS controller 140 to reduce, for example, diesel electrical generating sources over other generating sources due to the higher costs of diesel fuel.

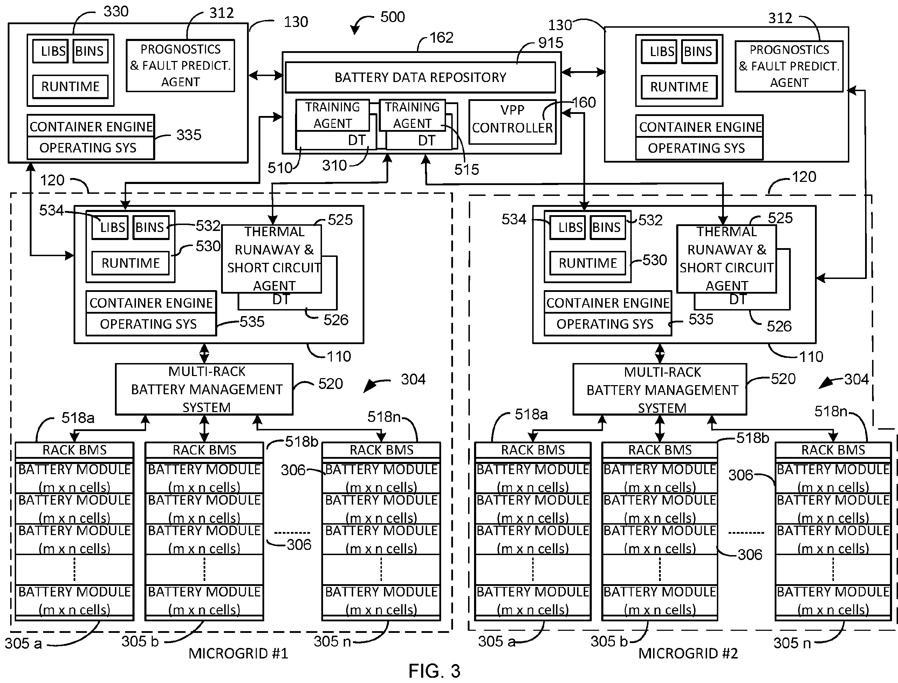

A system 500 for detecting anomalous outlier battery cells of a BESS battery in accordance with the present disclosure is shown in FIG 3. The system 500 is a distributed system that executes on the SCADA server 162, an ECS controller 130 and a BESS unit controller 110 associated with each BESS container 120. A prognostic and fault prediction agent 312 continually monitors operational data collected by the BESS unit controller 110 from a multi-rack battery management system 520. A BESS battery 304 contained in each container 120 is organized having a set number of battery cells composing a battery module with each battery module interconnected into a battery rack. As shown in FIG. 3 for each BESS container 120 illustrated, the BESS battery 304 comprises battery modules 306, having a number of individual battery cells, are connected in banks of serial and parallel connections and into a battery rack 305a, 305b-305n. Each battery rack 305a, 305b and 305n is managed by a rack battery management system 518a, 518b and 518n, that receives voltage, current, and temperature operational data from sensors (not shown) attached to each battery cell.

BESS unit controller 110 receives the operational battery data from a multi-rack battery management system that aggregates the battery data from the battery rack BMS 518a, 518b, 518n associated with battery racks 305a, 305b, 305n, respectively. The operational battery data includes voltage, current, temperature, SOC, and SOH of the battery cells within the battery modules 306. While voltage, current and temperature are measured directly from the sensors attached to the battery cells, SOC and SOH are inferred by the battery management system 520.

The battery operational data is periodically collected once during a time interval defined by a user or by the system 500 based on charge/discharge rates. For example, data may be collected every second or any larger interval such as 15 minutes or a few hours when the BESS is idling. The battery operational data from the battery management system 520 is sent by the BESS unit controller 110 to its battery data repository hosted on server 162 via its associated ECS controller 130. The cost of data storage is lowest in a cloud hosted platform, and highest in an embedded device. The data collected by BESS unit controller 110 from battery management system 520 is sent to a cloud hosted battery data repository 915 via an ECS controller 130, when a cloud hosted repository is available. However, in situations where cloud connectivity is not available, the battery data repository 915 will be hosted on an on-premises server.

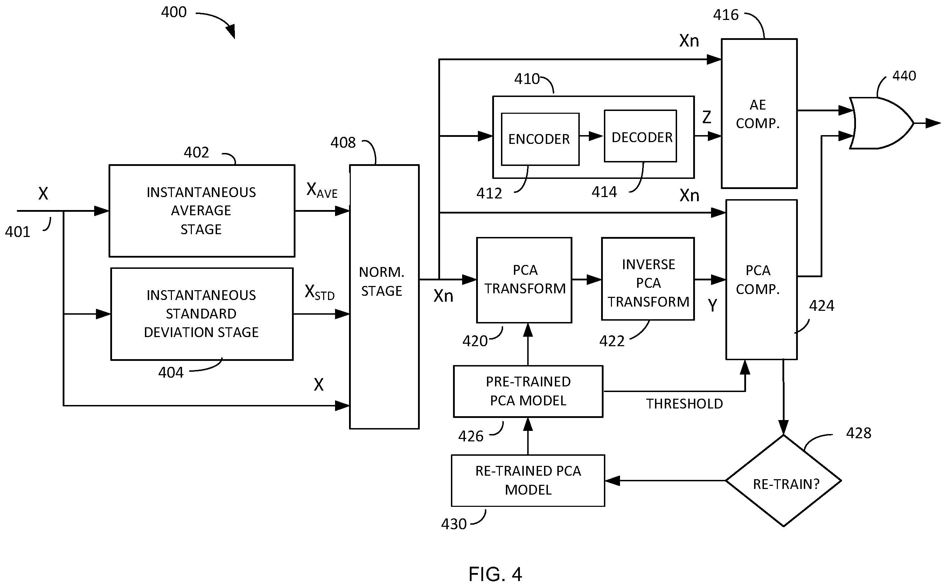

The prognostics and fault prediction agent 312 runs in the ECS controller 130 as a containerized software application by a processor 202 driven container engine 335. The containerized software applications includes all the binaries (BINS) and libraries (LIBS) required to run the prognostics and fault prediction agent 312 in a runtime system 335. Battery cell current, voltage and temperature data fetched by BESS unit controller 110 from the battery management system 520 is normalized by computing an instantaneous average and standard deviation calculation by an outlier battery cell detection method 400 shown in FIG. 4. A combination of unsupervised and supervised models is used to detect and identify outlier battery cells that may be contained in the BESS battery 304 and that are exhibiting anomalous behaviors. The outlier battery cell detection method will be explained later.

A BESS prognostic agent 510 executes on the energy control system SCADA server 162. The operational data collected by the BMS 520 and sent to ECS controller 130 is also coupled to a battery data repository 915 hosted on the energy control system server 162. The battery data repository 915 aggregates battery data from the multiple BESS containers 120. The battery data repository 915 may also be hosted in the cloud 168. A remote or cloud hosted battery data repository 915 is beneficial in enabling newer BESS installations to leverage the data generated by older BESS container 120 installation so that the models can be trained using data generated by the older BESS installations.

The battery operational data stored in the battery data repository 915 is coupled to and used by BESS prognostic agent 510 to train the prognostics & fault prediction agent 312. A prognostics training agent 515 and its digital twin DT 310 execute on the server 162 to continuously improve the prognostics & fault detection agent models 312 using any new data collected from the BESS containers 120 in the field. A digital twin is defined for the purposes of this disclosure, as a virtual model that uses real-time data to simulate the behavior of an asset or system and its operations including overseeing the performance of the asset or system to identify potential faults and make better-informed decisions about operations and lifecycle performance. The BESS prognostic agent 510 uses physics-based models parametrized using data driven methods of past time-series data of voltage, current and temperature to train recurrent neural networks. The retrained prognostics & fault prediction agent model is then downloaded to the associated BESS ECS 130.

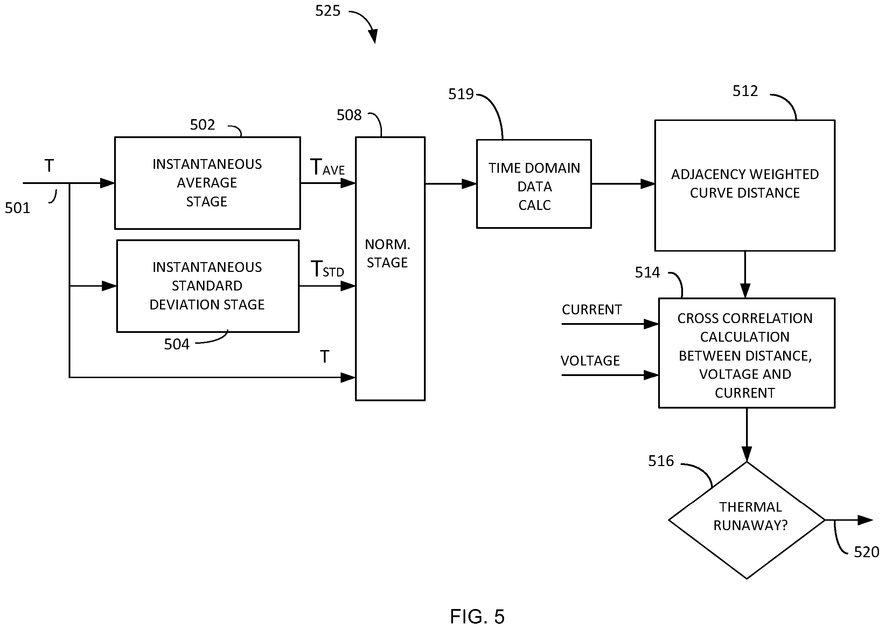

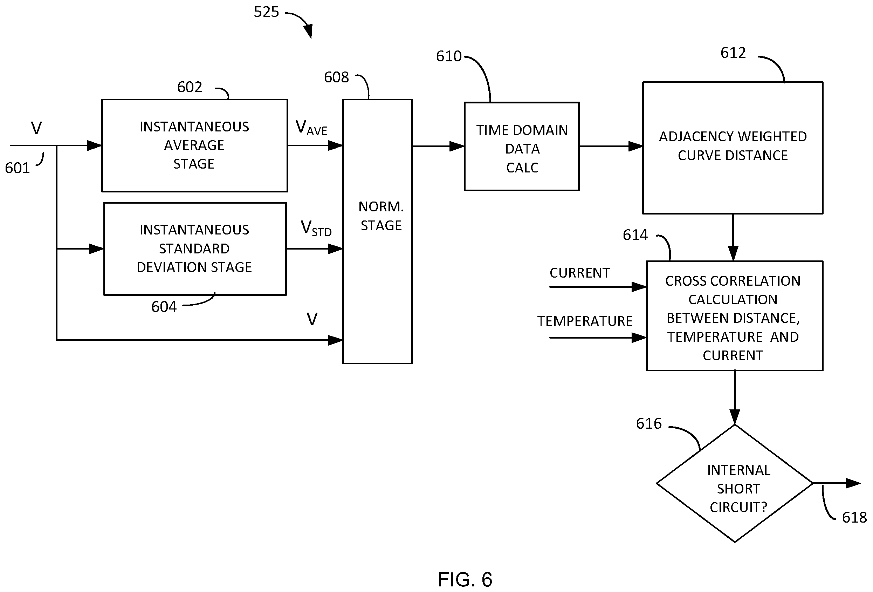

Thermal runaway and internal short circuits are two critical faults, which demand an extremely fast response when such a fault is detected. While BMS protection can prevent fire or explosion, it is not fast enough to save the battery. Hence early detection of a thermal or voltage movement that shows signs of progress towards a thermal runaway or a voltage drop to near zero due to short circuit is important to prevent further charge or discharge before BMS detects these faults. The system 500 includes a thermal runaway and short circuit agent 525 running in the BESS unit controller 110 that use a DT 526 within a containerized software application executed by a processor driven runtime 530 of the BESS unit controller 110. The containerized software 530 includes all the binaries (BINS) 532 and libraries (LIBS) 534 required to run the thermal runaway and short circuit agent 525 application as a container run time. Temperature and voltage data identified by the prognostics and fault prediction agent 312 as an outlier battery cell is input to the thermal runaway and short circuit agent 525 and used by a thermal runaway detection method 500 shown in FIG. 5 and an internal short circuit detection method 600 shown in FIG. 6. in order to detect battery cells of a BESS battery 304 that may potentially experience a thermal runaway or an internal short circuit.

FIG. 4 illustrates the method 400 for the detection of outlier battery cells. The method 400 is used by the prognostics and fault prediction agent 312 of system 500. It should be noted that each process operation and/or stage shown in FIG. 4 may be a software algorithm, an executable application, or a function module executing individually or concurrently to compute and detect outlier battery cells. The outlier battery cell detection method 400 is used to detect battery cells that are operating outside of normal operating parameters, in order to detect potential battery cell faults and avoid abnormal situations that can result in safety incidents. The outliers that the method 400 may detect include, but not limited to: battery cells with thermal sensor faults such as no/loose contact between sensor and cell surface; battery cells with lower-than-normal capacity due to poor manufacturing quality control; battery cells with reduced energy capacity due to ageing or abuse; battery cells with higher impedance with reduced power capacity; battery cells with internal short circuit within a cell; and battery cells with SOC imbalance or an SOC shift from remaining cells.

Battery cell voltage, current, and temperature data for battery cells contained in a battery module 306 is reported by sensors associated with BESS modules 306 to the BMS 520 and to the pretrained prognostic fault detection agent 312 running in ECS 130. The voltage, current and temperature data from the BMS 520 is applied to input 401 of method 400. The input data (X) is prepared for normalization by computing an instantaneous average calculation ($X_{AVE}$) using an instantaneous average stage 402 and a standard deviation calculation ($X_{STD}$) using an instantaneous standard deviation stage 404. The output $X_{AVE}$ from stage 402 and output $X_{STD}$ from stage 404 along with the input data X is coupled as inputs to a normalization stage 408. The normalization stage 408 outputs a normalized data output Xn using the calculation X-$X_{AVE}$ / $X_{STD}$. The normalized data output Xn is then coupled to a combination of unsupervised and supervised models to detect individual outlier battery cells of the BESS battery 304.

An autoencoder (AE) 410 receives the normalized data output Xn from the normalization stage 408. The AE 410 is a type of a neural network used to learn data patterns. A typical AE has two parts, an encoder 412 and a decoder 414. The encoder 412 encodes/compresses the input data into latent space variables, and the decoder 414 decodes/reconstructs the input from the latent variables. The AE learns an approximation to the identity function. The predicted output is similar to the input. By placing constraints on the network, i.e., limiting the number of hidden units, hidden structures in the data can be discovered. The AE 410 is used in an unsupervised learning setting in this disclosure, where the target labels of a dataset are not known, but there is known that there are a small number of outliers/anomalies in the dataset. The AE 410 learns regularities. Therefore, the AE will predict low reconstruction errors for normal examples and high reconstruction errors for anomalous errors. The reconstruction output Z of the AE 410 is applied to an AE comparator 416 along with the normalized Xn data output. The reconstruction error Z from the AE 410 is compared to a threshold-AE stored in the AE comparator 416 using the calculation Xn-Z > threshold AE and the output of the calculation is output from AE comparator 416 as outlier battery data. The outlier battery cell and its voltage, temperature and current data is input to OR gate 440 as outlier data and used to identify battery cell or cells operating in an anomalous manner.

The normalized output data Xn output by the normalization module 408 is also transformed using a pre-trained principal component analysis (PCA) model 420 with a single principal component and an inverse PCA transform model 422. The output of the inverse PCS transform 422 is a reconstructed data input (Y) applied as an input to a PCA comparator 424. The PCA model used in the PCA transform 420 is pre-trained in PCA model 426 using normal cell level voltage, temperature, and current data under the supervision of an expert user, such as a power technician. The pre-trained PCA transform model 426 also generates a threshold output that is input to the PCA comparator 424 as a threshold value. The PCA comparator 424 receives the normalized input data value Xn and the transform data input Y to detect outlier battery cells using the calculation Xn-Y > Threshold-1. Threshold-1 being the threshold transform from the pretrained PCA model 426. Battery cell outliers are detected when the difference between the normalized input data Xn and reconstructed data Y from PCA transform 420 and inverse transform 422 exceeds Threshold-1. Outlier battery cells and their voltage, temperature and current data are input to OR gate 440 as outlier data and used to identify battery cell or cells operating in an anomalous manner.

However, if the mean difference between the input data value Xn and the reconstructed data Y exceeds a second preconfigured threshold in module 424, e.g., Mean(Xn-Y) > Threshold-2 at decision stage 428 then the PCA transform is retrained as a retrained PCS model 430 with new normalized input data. The Threshold-2 is also determined during the PCA model training process, based on the residual error or difference between the original data and reconstructed data after PCA transform and inverse transform using training data from a good battery module.

The temperature data for outlier battery cells identified by the outlier battery cell detector of FIG. 4, is coupled to input 501 of a thermal runaway detection method 500 shown in FIG. 5. The thermal runaway method 500 is executed in the thermal runaway and short circuit agent 525 contained in each BESS unit controller 110 of a BESS container 120. It should be noted that each process operation shown in FIG. 5 may be a software algorithm, an executable application, or function module executing individually or concurrently to compute the thermal runaway detection method 500. Temperature data identified as emanating from an outlier battery cells is coupled to input 501. The input temperature data (T) is prepared for normalization by computing an instantaneous average calculation ($T_{AVE}$) using an instantaneous average stage 502 and a standard deviation calculation ($T_{STD}$) using an instantaneous average stage 504. The output $T_{AVE}$ from stage 502 and output $T_{STD}$ from stage 504 along with the input data T is coupled as inputs to a normalization stage 508. The normalization stage 508 calculates normalized zero mean data for the input temperature using calculation T-$T_{AVE}$ / $T_{STD}$ and unit standard deviation is next applied to a time domain data calculation in stage 519 to compute a time derivative using the calculation d/dt.

The normalized temperature data, from the normalization calculation 508 along with its time derivative calculation from stage 519 is used by an adjacency weighted curve distance neural network 512. The adjacency weighted curve distance neural network 512 computes three different curve distance metrics, a discrete Fréchet distance, a discrete Hausdorff distance and dynamic time warping. Weights and bias of the adjacency weighted curve distance neural network 512 array are computed considering the physical adjacency (or physical distance) of the battery cells of a battery module 306 cells to the outlier cell identified by the outlier battery cell detector method 400. The neural network training algorithm uses the physical distance during the training process to compute the weights and bias of the neural network 512. Unlike a conventional neural network, the neural network of the adjacency weighted curve distance neural network 512 uses the curve distances calculated using discrete Fréchet, discrete Hausdorff and dynamic time warping and considers the curve distances in addition to the physical distances. The curve distances are computed using an algorithm using a first principal computation for Fréchet distance, Hausdorff distance and dynamic time warping distance.

For example,

$$W_{IJ} \times FD_{IJ}(J) + W_{IJ} \times DTW_{IJ}(J) + W_{IJ} \times HD_{IJ}(J) + B_{IJ}$$

Where:

FD : Fréchet Distance

HD: Hausdorff Distance

DTW: Dynamic Time Warping

WIJ : Adjacency weight Matrix

J: The output from the time domain calculation 519

This may be broadly considered a physics informed neural network. The distance calculation provides important distance measurement to the cross correlation stage 514 that computes the cross correlation between an outlier cell's data to data from other cells in the same battery module 306. The cross correlation stage 514 is a convolutional neural network with a SoftMax output layer, which makes use of the fact that a convolutional neural network can compute the cross correlation between the inputs. The SoftMax layer gives a probabilistic measure of the probable output and can be useful as a confidence measure of the output with a higher confidence when there is a large difference between highest output or fault type to remaining outputs or fault types, where all outputs add up to 1, and a lower confidence when the difference between highest output and remaining outputs are low. Cross correlation between the curve distance computed in adjacency stage 512 and the outlier cell voltage and current data is next computed in stage 514 to detect if the cross correlation value exceeds a threshold when current and/or rate of change of voltage also exceeds thresholds, in order to determine whether a thermal runaway has started.

For example:

$$Cross\ Correlation > T_{threshold};$$

$$Current > I_{threshold}$$

$$dv/dt > V_{threshold}$$

If it is determined in decision stage 516 that a thermal runway has started or about to occur an output signal on output 520 is coupled the BESS unit controller 110 signaling to the server 162 to provide notification to a monitoring system or to field technicians of an outlier battery cell that may experience a thermal runaway, so corrective actions may be taken.

FIG. 6 depicts a method 600 for the detection of an internal short circuit of the battery cells of a BESS battery 304. The method 600 is similar to the method shown in FIG. 5, however, the short circuit detection method 600 uses voltage data instead of temperature data. It should be noted that each process operation shown in FIG. 6 may be a software algorithm, an executable application, or function module executing individually or concurrently to compute detection of internal short circuits in an outlier battery cell. The voltage data for outlier battery cells identified by the outlier battery cell detector of FIG. 4, is coupled to input 601 of the internal short circuit detection method 600. The method 600 is executed in real time in the thermal runaway and short circuit agent 525 contained in each unit controller 110 of a BESS container 120. Voltage data identified as emanating from an outlier battery cell is coupled to input 601. The input voltage data (V) is prepared for normalization by computing an instantaneous average calculation ($V_{AVE}$) using an instantaneous average stage 602 and a standard deviation calculation ($V_{STD}$) using an instantaneous standard deviation stage 604. The output $V_{AVE}$ from module 602 and output $V_{STD}$ from module 604 along with the input voltage data V is coupled as inputs to a normalization stage 608. The normalization stage 608 calculates normalized zero mean data for the voltage using the calculation $V-V_{AVE} / V_{STD}$ and unit standard deviation is next applied in a time domain data calculation in stage 610 to compute a time derivative using the calculation d/dt.

The normalized voltage data, from the normalization stage 608 along with its time derivative calculation from stage 610 is used in an adjacency weighted curve distance neural network 612. The adjacency weighted curve distance neural network 612 computes three different curve distance metrics, a discrete Fréchet distance, a discrete Hausdorff distance and dynamic time warping. Weights and bias of the adjacency weighted curve distance neural network 612 array are computed considering the physical adjacency (or physical distance) of the battery cells of a battery module 306 cells to the outlier battery cell identified by the outlier battery cell detector 400. The neural network training algorithm uses the physical distance during the training process to compute the weights and bias of the neural network 612. Unlike a conventional neural network, the neural network of the adjacency weighted curve distance neural network 612 uses the curve distances calculated using discrete Fréchet , discrete Hausdorff and dynamic time warping and considers the curve distances in addition to the physical distances. The curve distances are computed using an algorithm that uses a first principles computation for Fréchet distance, Hausdorff distance and dynamic time warping distance.

For example:

$$W_{IJ} \times FD_{IJ}(J) + W_{IJ} \times DTW_{IJ}(J) + W_{IJ} \times HD_{IJ}(J) + B_{IJ}$$

Where:

FD : Fréchet Distance

HD: Hausdorff Distance

DTW: Dynamic Time Warping

$W_{IJ}$ : Adjacency weight Matrix

J: The output from the Time domain calculation 610

The first derivative in time is useful to detect a voltage change, more specifically a negative value, when the voltage drops due to an internal short circuit. Such a voltage movement in any one or a few cells that does not occur in all battery cells can be detected when the curve distance between the outlier battery cells and other battery cells are computed, followed by a cross correlation calculation at stage 614.

Cross correlation between the curve distance computed in adjacency stage 612 and the outlier battery cell voltage and current data is next computed in stage 614 to detect if the cross correlation value exceeds a threshold when current and/or rate of change of voltage also exceeds thresholds, to determine whether an internal short circuit has occurred.

For example:

$$\text{Cross Correlation} > T_{threshold};$$

Current > $I_{threshold}$

dv/dt > $V_{threshold}$

A high cross correlation, which coincides with a high current and temperature can be a good indicator of an internal short circuit, particularly when the time derivative of voltage increased with a negative slope. If it is determined in decision stage 616 that an internal short circuit has occurred an output signal 618 is coupled the BESS unit controller 110 that informs the server 162 to send notifications to a monitoring system or to field technicians of the internal short circuit of a battery cell or cells.

Outlier battery cells detected using the battery cell outlier detector of FIG. 4 may be further analyzed using a data classification neural network system 710, that uses a first principles-based distance calculation between outlier cell data and normalized cell data with zero mean and unit standard deviation. This may be broadly considered a physics informed neural network, combining the curve distance of multiple parallel data collected from battery cells that have a physical distance relationship in a battery module.

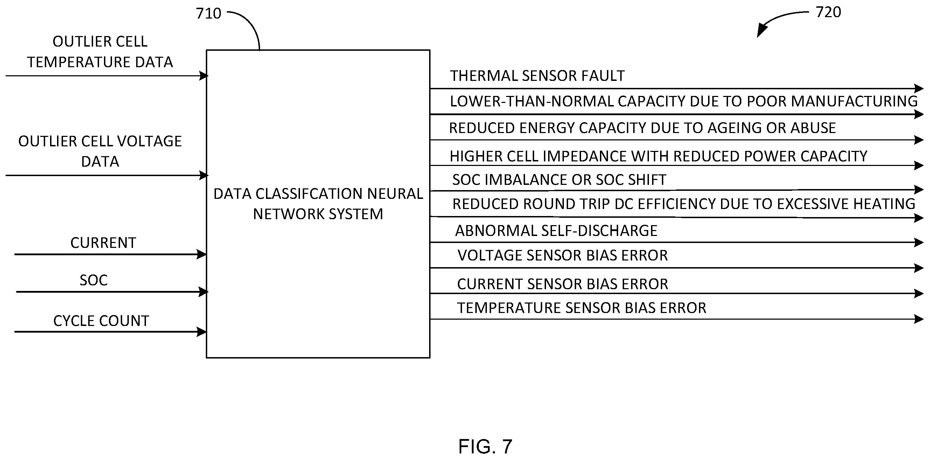

As shown in FIG. 7 outlier battery cell data, comprising the outlier cell(s) and outlier cell data, for all of the battery cells in a battery module 306 containing the identified outlier cell(s) is input to the data classification neural network system 710. The data input to the data classification neural network system 710 includes voltage, temperature, current SOC, and cycle count. The data classification neural network 710 uses a cell physical adjacency weighted, temporal and spectral distance informed, outlier classification neural network to categorize the fault to one of 10 faults shown at 720.

The distance informed neural network computes three different curve distance metrics: discrete Fréchet distance, discrete Hausdorff distance and dynamic time warping. Time domain data, its first derivative in time and its transform to frequency domain is applied to a sliding fast Fourier transform (FFT) function to calculate the real time frequency spectrum on a sample by sample basis. The data classification neural network system 710 is executed in the prognostic agent 510 executing on server 162 or in an edge controller device that has adequate computing and memory resources to run the algorithms of the data classification neural network system 710. For non-real time calculations, offline computation on a cloud hosted or server platform, may be implemented as containerized applications, so that it can be trained and deployed on either the cloud, a server, or an edge controller device.

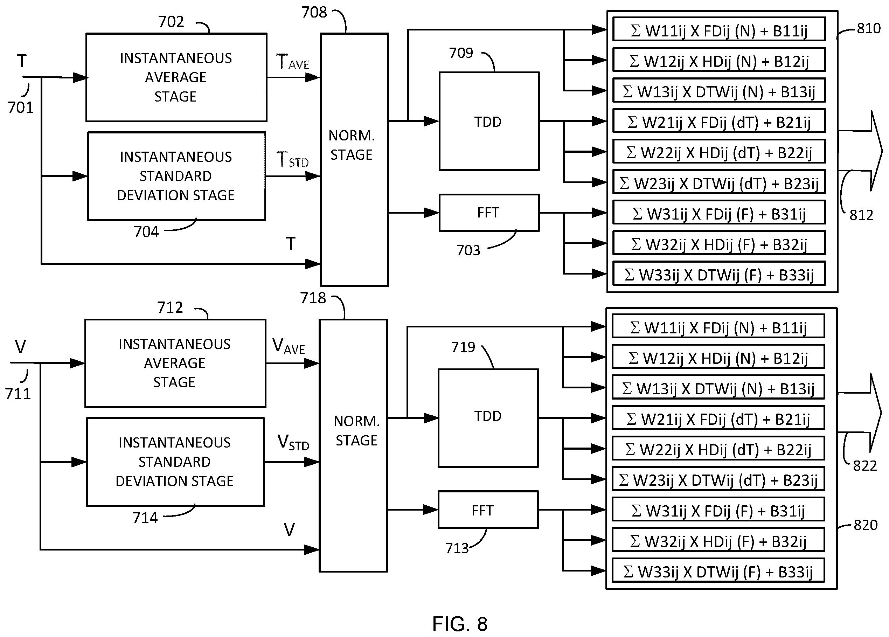

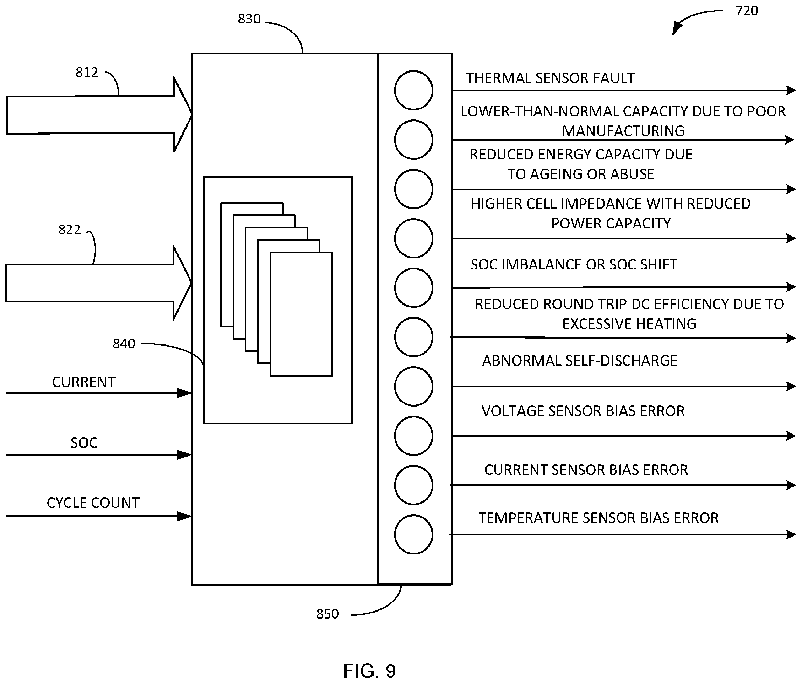

The system and method of the data classification neural network system 710 is illustrated in FIGS. 8 and 9. The temperature data for an outlier battery cell(s) identified by the outlier battery cell detector of FIG. 4, is coupled to input 701 of the data classification neural network system 710. It should be noted that each process operation shown in FIG. 8 may be a software algorithm, an executable application, or function module executing individually or concurrently to compute the data classification neural network system 710.

With reference to FIG. 8, temperature data identified as emanating from an outlier battery cell(s) is coupled to input 701. The input temperature data (T) is prepared for normalization by computing an instantaneous average calculation ($T_{AVE}$) using an instantaneous average stage 702 and a standard deviation calculation ($T_{STD}$) using an instantaneous standard deviation stage 704. The output $T_{AVE}$ from stage 702 and output $T_{STD}$ from stage 704 along with the input data T is coupled as inputs to a normalization stage 708. The normalization stage 708 calculates normalized zero mean data for the input temperature using the calculation $T-T_{AVE}/T_{STD}$. A time domain derivative (TDD) is next calculated by stage 709 with the output of normalization stage 708 using the calculation d/dt. The normalization output from stage 708 is also applied to a fast Fourier transform (FFT) stage 703 that adds a first derivative in time and its transform to the frequency domain using a sliding FFT function to calculate the real time frequency spectrum on a sample by sample basis, so that the windowed spectral data can be input to the curve distance computation blocks 810 along with time domain data.

Similarly, as with the temperature data, voltage data identified as emanating from an outlier battery cell(s) is coupled to input 711. The input voltage data (V) is prepared for normalization by computing an instantaneous average calculation ($V_{AVE}$) using an instantaneous average stage 712 and a standard deviation calculation ($V_{STD}$) using an instantaneous standard deviation stage 714. The output $V_{AVE}$ from module 712 and output $V_{STD}$ from module 714 along with the input voltage data V is coupled as inputs to a normalization stage 718. The normalization stage 718 calculates normalized zero mean data for the voltage using the calculation $V-V_{AVE}/V_{STD}$. A TDD is next calculated by stage 719 with the output of normalization stage 718 using the calculation d/dt. The normalization output from stage 718 is also applied to a fast Fourier transform (FFT) stage 713 that adds a first derivative in time and its transform to the frequency domain using a sliding FFT function to calculate the real time frequency spectrum on a sample by sample basis, so that the windowed spectral data can be input to the curve distance computation blocks 820 along with time domain data.

The normalized temperature and voltage data, from the normalization stage 708, 718 along with its time derivative calculation from stage 709, 719 and FFT stage 703, 713 are next applied to an adjacency weighted curve distance computation neural network array 810, 820. Array 810 calculates adjacency for the temperature T and array 820 for voltage V. Weights and bias of the array of neural networks are computed considering the physical adjacency (or physical distance) of the cells in the battery module 306 to the outlier cell(s). The neural network training algorithm uses the calculated physical distance during the training process to compute the weights and bias of the network. Unlike a conventional neural network, the adjacency weighted curve distance computation neural network array 810, 820 uses the curve distances calculated using a discrete Fréchet distance (FD), a discrete Hausdorff distance (HD) and dynamic time warping distance (DTW) that also considers the curve distances in addition to the physical distances of the outlier battery cell(s) to the cells in the battery module containing the outlier cell(s). A curve distances matrix is computed using algorithms that use first principles computation for Fréchet distance, Hausdorff distance and dynamic time warping distance for the temperature and voltage data from a respective normalization stage 708, 718, time derivative stage 709, 719 and FFT stage 703, 713.

For example, for the output from the temperature normalization stage 708 an adjacency weighted curve distance for a normalized curve distance matrix is calculated using:

$\Sigma$ W11ij XFDij (N) + B11ij, where W11ij is the adjacency weight matrix for the Fréchet distance (FD) between a normalized (N) curve of outlier cell(s) to other cells in the module;

$\Sigma$ W12ij X HDij (N) + B12ij, where W12ij is the adjacency weight matrix for the Hausdorff distance (HD) between a normalized (N) curve of outlier cell(s) to other cells in the module; and

$\Sigma$ W13ij X DTWij (N) + B13ij, where W13ij is the adjacency weight matrix for the dynamic time warping (DTW) distance between a normalized (N) curve of outlier cell(s) to other cells in the module.

For the output from the temperature time derivative stage 709 an adjacency weighted curve distance matrix for a gradient curve distance matrix is calculated using:

$\Sigma$ W21ij X FDij (dT) + B21ij, where W21ij is the adjacency weight matrix for the Fréchet distance (FD) between a gradient (dt) curve of outlier cell(s) to other cells in the module;

$\Sigma$ W22ij X HDij (dT) + B22ij, where W22ij is the adjacency weight matrix for the Hausdorff distance (HD) between a gradient (dt) curve of outlier cell(s) to other cells in the module; and

$\Sigma$ W23ij X DTWij (dT) + B23ij, where W23ij is the adjacency weight matrix for the dynamic time warping distance (DTW) between a gradient (dt) curve of outlier cell(s) to other cells in the module.

For the output from the temperature FFT stage 703 an adjacency weighted curve distance matrix for a frequency spectral curve distance matrix is calculated using:

$\Sigma$ W31ij X FDij (F) + B31ij, where W31jj is the adjacency weight matrix for the Fréchet distance (FD) between frequency (F) spectral gradient curve of outlier cell(s) to other cells in the module;

$\Sigma$ W32ij X HDij (F) + B32ij, where W32ij is the adjacency weight matrix for the Hausdorff distance (HD) between frequency (F) spectral gradient curve of outlier cell(s) to other cells in the module; and

$\Sigma$ W33ij X DTWij (F) + B33ij, where W33ij is the adjacency weight matrix for the dynamic time warping distance (DTW) frequency (F) spectral gradient curve of outlier cell(s) to other cells in the module.

A similar matrix for discreet Fréchet distance, discreet Hausdorff distance and dynamic time warping is built for the outlier cell(s) for a voltage data adjacency weighted curve distance computation by neural network array 820.

This may be broadly considered a physics informed neural network, combining the curve distance of multiple parallel data collected from battery cells that have a physical distance relationship in the battery module.

This distance calculations 812 and 822 are input as distance measurements to the final stage of the data classification neural network system 710 that calculates the cross correlation between an outlier cell's data to the data from other cells in the same battery module. With reference to FIG. 9, a final stage 830 performs a cross correlation using a convolutional neural network 840 with a SoftMax output layer 850. The convolutional neural network layer 840 computes the cross correlation between the distance calculations provided by outputs 812 ad 822 of the weighted curve distance computations 810 and 820 respectively, and input current, SOC and cycle count from the battery module containing the outlier cell(s).

The last activation layer of the convolutional neural network 830 is the SoftMax layer 850 that normalizes the output of the convolutional neural network 840 to a probability distribution of a potential fault type 720. The probabilistic measure output by the SoftMax layer 850 provides a higher confidence measure of a potential fault type 720 when there is a large difference between the highest output for one fault type to other remaining outputs or fault types, where all outputs add up to one, and a lower confidence when the difference between highest output and remaining outputs are close to zero.

It may be advantageous to set forth definitions of certain words and phrases used throughout this patent document. The term "discreet Fréchet distance" is the measure of similarity between curves that considers the location and ordering of the points along the curves. The term " discreet Hausdorff distance," is the measure of how similar or dissimilar two geometries are, computed at discreate points of the geometries. The term "dynamic time warping" is an algorithm measurement of similarity between two temporal sequences, which may vary in speed. The term "communicate," as well as derivatives thereof, encompasses both direct and indirect communication. The terms "include" and "comprise," as well as derivatives thereof, mean inclusion without limitation. The term "or" is inclusive, meaning and/or. The phrase "associated with," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, have a relationship to or with, or the like. The phrase "at least one of," when used with a list of items, means that different combinations of one or more of the listed items may be used, and only one item in the list may be needed. For example, "at least one of: A, B, and C" includes any of the following combinations: A, B, C, A and B, A and C, B and C, and A and B and C.

The description in the present application should not be read as implying that any particular element, step, or function is an essential or critical element that must be included in the claim scope. The scope of patented subject matter is defined only by the allowed claims. Moreover, none of the claims is intended to invoke 35 U.S.C. § 112(f) with respect to any of the appended claims or claim elements unless the exact words "means for" or "step for" are explicitly used in the particular claim, followed by a participle phrase identifying a function. Use of terms such as (but not limited to) "mechanism," "module," "device," "unit," "component," "element," "member," "apparatus," "machine," "system," or "controller" within a claim is understood and intended to refer to structures known to those skilled in the relevant art, as further modified or enhanced by the features of the claims themselves and is not intended to invoke 35 U.S.C. § 112(f).

While this disclosure has described certain embodiments and generally associated methods, alterations and permutations of these embodiments and methods will be apparent to those skilled in the art. Accordingly, the above description of example embodiments does not define or constrain this disclosure. Other changes, substitutions, and alterations are also possible without departing from the spirit and scope of this disclosure, as defined by the following claims.

## Claims

1. A system for detecting and classifying outlier battery cells operating abnormally in a storage battery of an energy storage system (BESS), the system comprising:

   a controller for controlling the operation of the BESS;
   a battery management system (BMS) coupled to the storage battery configured to collect battery operational data from the storage battery;
   a battery data repository coupled to the BMS for receiving and storing the storage battery operational data; and
   a prognostic agent coupled to the battery data repository that uses the stored battery operational data to train a prognostics and fault detection model,
   wherein the controller receives and uses the prognostics and fault detection model to detect at least one outlier battery cell.

2. The system of Claim 1, wherein the prognostics and fault detection model further includes:

   an instantaneous average stage that receives at least one of temperature, voltage and current data of the storage battery provided to the controller from the BMS to calculate an average measurement for the at least one of temperature, voltage, and current data of the storage battery;
   an instantaneous standard deviation stage that receives at least one of temperature, voltage and current data of the storage battery provided to the controller from the BMS and calculate a standard deviation measurement for the at least one of temperature, voltage, and current data of the storage battery; and
   a normalization stage that receives the average measurement, the standard deviation measurement, and the at least one temperature, voltage, and current data of the storage battery data to calculate normalized data measurements.

3. The system of Claim 2, wherein an unsupervised autoencoder (AE) neural network stage is connected to the normalization stage and arranged to receive the normalized data measurements and using the normalized data measurements to discover anomalies in the normalized data measurements and to output discovered anomalous errors to an AE comparator that compares the anomalous errors from the AE with the normalized data measurements to identify a potential outlier battery cell.

4. The system of Claim 3, wherein a supervised principal component analysis (PCA) stage is connected to the normalization stage and is arranged to receive the normalized data measurements and using the normalized data measurements to generate an inverse PCA transform and a threshold data output, wherein the inverse PCA transform and the threshold data is input to a PCA comparator that compares the inverse PCA transform and threshold data to the normalized data measurements to identify a potential outlier battery cell.

5. The system of Claim 4, wherein a decision gate is connected to the AE comparator and the PCA comparator and is arranged to receive the potential outlier battery cells from the AE comparator and the PCA comparator and detect the at least one outlier battery cell.

6. The system of Claim 5, wherein the prognostics and fault detection model further includes:
a data classification neural network connected to the decision gate that is arranged to receive the at least one detected outlier battery cell and the outlier battery cell temperature, voltage, and current data, wherein the classification neural network is arranged to derive a physical adjacency of other battery cells contained in the battery storage system to the detected at least one outlier battery cell.

7. The system of Claim 6, wherein an adjacency weighted curve distance neural network is connected to data classification neural network and is arranged to compute curve distance measurements using the temperature and voltage data of the detected at least one outlier battery cell using a discrete Fréchet distance, a discrete Hausdorff distance and dynamic time warping.

8. The system of Claim 7, wherein a convolutional neural network connected to the adjacency weighted curve distance neural network is arranged to receive the curve distance measurements from the adjacency weighted curve distance neural network and calculate a cross correlation data output between the detected at least one outlier battery cell temperature and voltage measurements and a current, state of charge SOC and cycle count of the storage battery.

9. The system of Claim 8, wherein the convolutional neural network includes:
a SoftMax layer that receives the cross correlation data output from the convolutional neural network and normalizes the output of the convolutional neural network to a probability distribution of a potential fault type for the detected at least one outlier battery cell.

10. The system of Claim 5, wherein the system further includes a thermal runaway and short circuit agent connected to the decision gate and arranged to receive the detected at least one outlier battery cell temperature measurement.

11. The system of Claim 10, wherein the thermal runaway and short circuit agent further includes:

an instantaneous average stage that receives the at least one outlier battery cell temperature and is arranged to calculate an average outlier battery cell temperature measurement;
an instantaneous standard deviation stage that receives the at least one outlier cell temperature measurement, and is arranged to calculate an outlier cell standard deviation temperature measurement; and
a normalization stage that receives the average temperature measurement, the standard deviation temperature measurement and the at least one outlier cell temperature to calculate a normalized zero mean data output; and
a time domain data stage connected to the normalization stage arranged to receive the normalized zero mean data output and calculate a time derivative data output.

12. The system of Claim 11, wherein the thermal runaway and short circuit agent further includes:

an adjacency weighted curve distance neural network connected to the time domain data stage arranged to compute curve distance measurements using the normalized zero mean data output and the time derivative data output using a discrete Fréchet distance, a discrete Hausdorff distance and dynamic time warping; and
a cross correlation stage connected to the adjacency weighted curve distance neural network that is arranged to receive the curve distance measurements and the at least one outlier cell current and voltage to determine a cross correlation between the distance measurements and the detected at least one outlier battery cell's current and voltage to determine if a thermal runaway of the detected outlier battery cell has started.

13. The system of Claim 5, wherein the system further includes a thermal runaway and short circuit agent connected to the decision gate and arranged to receive the detected at least one outlier battery cell voltage measurement.

14. The system of Claim 11, wherein the thermal runaway and short circuit agent further includes:

an instantaneous average stage that receives the at least one outlier battery cell voltage and is arranged to calculate an average outlier battery cell voltage measurement;
an instantaneous standard deviation stage that receives the at least one outlier cell voltage measurement, and is arranged to calculate an outlier cell standard deviation voltage measurement; and
a normalization stage that receives the average voltage measurement, the standard deviation voltage measurement and the at least one outlier cell voltage to calculate a normalized zero mean data output;

a time domain data stage connected to the normalization stage arranged to receive the normalized zero mean data output and calculate a time derivative data output;

an adjacency weighted curve distance neural network connected to the time domain data stage arranged to compute curve distance measurements using the normalized zero mean data output and the time derivative data output using a discrete Fréchet distance, a discrete Hausdorff distance and dynamic time warping; and

a cross correlation stage connected to the adjacency weighted curve distance neural network that is arranged to receive the curve distance measurements and the at least one outlier cell current and temperature to determine a cross correlation between the distance measurements and the at least one outlier battery cell's current and voltage to determine if a short circuit of the detected outlier battery cell has occurred.

15. A method for detecting and classifying outlier battery cells operating abnormally in a storage battery of an energy storage system (BESS), the method comprising:

providing a controller for controlling the operation of the BESS;

collecting battery operational data from the storage battery system using a battery management system (BMS) coupled to the storage battery;

storing the storage battery operational data in a battery data repository;

training a prognostics and fault detection model using the battery data stored in the data repository; and

sending the trained prognostics and fault detection model to the controller to detect at least one outlier battery cell.

FIG. 1

MICROGRID 1 — 120
- 130 ECS
  - 140 MICROGRID ECS CONTROLLER
  - 135 BESS ECS CONTROLLER
- 110 BESS UNIT CONTROLLER

MICROGRID 2 — 120
- 130 ECS
  - 140 MICROGRID ECS CONTROLLER
  - 135 BESS ECS CONTROLLER
- 110 BESS UNIT CONTROLLER

120'
- 110' BESS UNIT CONTROLLER

160
- 162
- 164
- 168

108

100

EP 4 641 231 A1

15

FIG. 2

130

140 — MICROGRID ECS CONTROLLER

135 — BESS ECS CONTROLLER

201

202 — PROCESSOR

210 — MEMORY

215 — ECS SERVER INTERFACE

220 — MODBUS TCP INTERFACE

200 — NTWRK SWITCH

205 — NTWRK SWITCH

FIG. 3

EP 4 641 231 A1

FIG. 4

FIG. 5

FIG. 6

FIG. 7

FIG. 8

EP 4 641 231 A1

830

720

812

822

840

CURRENT

SOC

CYCLE COUNT

THERMAL SENSOR FAULT

LOWER-THAN-NORMAL CAPACITY DUE TO POOR MANUFACTURING

REDUCED ENERGY CAPACITY DUE TO AGEING OR ABUSE

HIGHER CELL IMPEDANCE WITH REDUCED POWER CAPACITY

SOC IMBALANCE OR SOC SHIFT

REDUCED ROUND TRIP DC EFFICIENCY DUE TO EXCESSIVE HEATING

ABNORMAL SELF-DISCHARGE

VOLTAGE SENSOR BIAS ERROR

CURRENT SENSOR BIAS ERROR

TEMPERATURE SENSOR BIAS ERROR

850

FIG. 9

**EP 4 641 231 A1**

| | Europäisches Patentamt / European Patent Office / Office européen des brevets | **EUROPEAN SEARCH REPORT** | **Application Number** EP 25 16 7705 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/091083 A1 (FRISCH ISRAEL [US] ET AL) 11 April 2013 (2013-04-11) | 1,15 | INV. G01R31/367 |
| A | * paragraph [0024] - paragraph [0063] * ----- | 2-14 | G01R31/392 H01M10/48 |
| A | US 2023/184839 A1 (MURPHY EVAN [US] ET AL) 15 June 2023 (2023-06-15) * paragraph [0019] - paragraph [0101] * ----- | 1-15 | |
| A | KIM TAESIC ET AL: "Efficient On-Board Health Monitoring for Multicell Lithium-Ion Battery Systems Using Gaussian Process Clustering", 2018 IEEE ENERGY CONVERSION CONGRESS AND EXPOSITION (ECCE), IEEE, 23 September 2018 (2018-09-23), pages 5604-5609, XP033463837, DOI: 10.1109/ECCE.2018.8557769 [retrieved on 2018-12-03] * the whole document * ----- | 1-15 | |

| | | | TECHNICAL FIELDS SEARCHED (IPC) |
| | | | G01R H01M |

The present search report has been drawn up for all claims

| Place of search | Date of completion of the search | Examiner |
|---|---|---|
| Munich | 11 September 2025 | Meggyesi, Zoltán |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 7705

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2025

| Patent document cited in search report | Publication date | Patent family member(s) | | Publication date |
|---|---|---|---|---|
| US 2013091083 A1 | 11-04-2013 | CA | 2786067 A1 | 10-04-2013 |
| | | CN | 103035961 A | 10-04-2013 |
| | | EP | 2581754 A2 | 17-04-2013 |
| | | US | 2013091083 A1 | 11-04-2013 |
| US 2023184839 A1 | 15-06-2023 | EP | 4409309 A2 | 07-08-2024 |
| | | KR | 20240121276 A | 08-08-2024 |
| | | US | 2023184839 A1 | 15-06-2023 |
| | | US | 2024192276 A1 | 13-06-2024 |
| | | WO | 2023107710 A2 | 15-06-2023 |

EPO FORM P0459

For more details about this annex : see Official Journal of the European Patent Office, No. 12/82